# EUROPÄISCHE PATENTSCHRIFT

(11) **EP 0 903 064 B1**
(45) Veröffentlichungstag und Bekanntmachung des Hinweises auf die Patenterteilung: **18.10.2000**
(21) Anmeldenummer: 97925976.9
(22) Anmeldetag: 02.06.1997
(51) Int. Cl.: H05K 5/04, F16B 5/06, H05K 9/00

(54) **GEHÄUSE**
HOUSING
BOITIER

(30) Priorität: 04.06.1996 DE 29609873 U
(43) Veröffentlichungstag der Anmeldung: 24.03.1999
(73) Patentinhaber: Knürr-Mechanik für die Elektronik AG, D-81829 Munchen (DE)
(72) Erfinder: FLAMME, Hans, D-82008 Unterhaching (DE); RAITH, Robert, D-81541 München (DE)
(74) Vertreter: Heim, Hans-Karl, Dipl.-Ing.
(86) Internationale Anmeldenummer: EP9702857
(87) Internationale Veröffentlichungsnummer: WO9747166

(56) Entgegenhaltungen:
- DE-A- 3 444 668
- DE-U- 8 805 804
- FR-A- 1 089 701
- GB-A- 2 211 026
- US-A- 3 862 535

## Beschreibung

Die Erfindung betrifft ein Gehäuse zur Aufnahme von elektrischen und elektronischen Baugruppen gemäß dem Oberbegriff des Anspruchs 1; (vgl. DE-A-3 444 668).

Bekannte Gehäuse, insbesondere Tischgehäuse, bestehen aus U-förmigen Gehäuseschalen und einer Front- und Rückplatte. Die Gehäuseschalen werden in der Regel im Bereich ihrer seitlichen Längskanten mit Befestigungsschrauben miteinander verbunden. Die Frontplatte und/oder die Rückplatte werden in Nuten, welche im Bereich einer stirnseitigen und/oder einer rückseitigen Öffnung in den Gehäuseschalen ausgebildet sind, aufgenommen. Eine Befestigung der Frontplatte bzw. Rückplatte erfolgt mit Befestigungsschrauben oder Verriegelungsbolzen, die in Steckprofilen im Gehäuseinneren mit Gewindeleisten gesichert werden.

Diese bekannte Befestigung einer Frontplatte und/oder einer Rückplatte ist zeit- und materialaufwendig, was sich negativ auf die Fertigungskosten der Gehäuse auswirkt. Eine weitere Kostenerhöhung ergibt sich, wenn eine EMV-Abschirmung und IP-Dichtigkeit gefordert wird.

Der Erfindung liegt die **Aufgabe** zugrunde, eine Gehäusekonstruktion zu schaffen, welche eine kostengünstige Befestigung einer Frontplatte und/oder einer Rückplatte ermöglicht und in einer besonders effizienten Weise gleichzeitig eine EMV-Abschirmung und IP-Dichtigkeit gewährleistet.

Erfindungsgemäß wird die Aufgabe durch die kennzeichnenden Merkmale des Anspruchs 1 gelöst. Zweckmäßige und vorteilhafte Ausgestaltungen sind in den Unteransprüchen und in der Figurenbeschreibung enthalten.

Die Erfindung basiert auf dem Grundgedanken, eine Frontplatte schraublos in einer frontseitigen Öffnung eines Gehäuses, insbesondere eines aus zwei Gehäuseschalen bestehenden Kleingehäuses, zu fixieren. Die schraublose Befestigung der Frontplatte erfolgt dabei unter Einbeziehung und mit Hilfe einer Kombination eines elastischen Dichtungsprofils und leitfähiger Federelemente, welche sowohl die Befestigung der Frontplatte am Gehäuse als auch eine EMV-Abschirmung und IP-Abdichtung gewährleistet.

Erfindungsgemäß wirken ein etwa rechtwinklig in eine frontseitige Gehäuseöffnung ragender Haltesteg und eine Anordnung aus leitfähigen Federelementen und einer elastischen Dichtung derart zusammen, daß eine Klemm- oder Rastbefestigung der Frontplatte in der frontseitigen Öffnung gewährleistet ist und Schraub- oder Bolzenbefestigungen entfallen können.

Es ist vorteilhaft, daß die leitfähigen Federelemente, welche haken- oder klammerartig ausgebildet sind, als ein EMV-Federband angeordnet sein können, welches in unterschiedlichen Abmessungen abgelängt und eingesetzt werden kann.

Indem die EMV-Federelemente, insbesondere als ein Federband, auf Längskanten der Frontplatte aufgesteckt werden können und von einer darüber angeordneten elastischen Dichtung, welche insbesondere als ein Dichtrahmen ausgebildet ist, gehalten werden, ist eine besonders rasche und unkomplizierte Befestigung einer Frontplatte möglich.

Zweckmäßigerweise wird der eine IP-Dichtung bewirkende Dichtrahmen aus einem Dichtungsprofil gebildet, welches auf Länge geschnitten und danach verbunden werden kann. Das Dichtungsprofil und die EMV-Federelemente sind dabei derart ausgebildet, daß eine sichere Steckhalterung auf den Kanten der Frontplatte erreichbar ist.

Sinnvollerweise sind die EMV-Federelemente mit etwa U-förmigen Aufsteckbereichen versehen, welche die stirnseitigen Kanten der Frontplatte umgreifen. Ein Klemmsteg, welcher nahezu rechtwinklig von dem U-förmigen Aufsteckbereich absteht und in das Gehäuse gerichtet ist, weist als ein Rast- oder Klemmelement eine Ausprägung oder Austanzung auf, die in Richtung Gehäuse auskragt.

Mit der Ausstanzung oder Ausprägung kann eine mit der erfindungsgemäßen Dichtungs- und Abschirmanordnung versehene Frontplatte an einem umlaufenden Haltesteg der Gehäuseöffnung verklemmt oder verrastet werden. Zu diesem Zweck sind die EMV-Federelemente und der Haltesteg sowie das Dichtungsprofil derart dimensioniert, daß der erforderliche Klemmeffekt erreichbar ist.

Zweckmäßigerweise ist das Dichtungsprofil bzw. der Dichtrahmen, welcher maßgeblich zur Halterung der EMV-Federelemente beiträgt, aus einem Kunststoffmaterial mit einer derartigen Elastizität gefertigt, daß der Klemmeffekt und eine sichere Halterung einer Abdeckplatte gewährleistet sind.

Eine konstruktive Ausbildung des Dichtungsprofils mit einem Außenschenkel, welcher den Außenbereich der EMV-Federelemente und den Bereich zwischen einem Kantenbereich des Gehäuses und der Frontplatte überdeckt, sichert gleichzeitig eine ästhetisch vorteilhafte Ansicht der Gehäuseseite.

Obwohl die erfindungsgemäße Lösung anhand der schraublosen Befestigung einer Frontplatte in einem Kleingehäuse beschrieben wurde, ist die Erfindung nicht auf diese Anwendung beschränkt. In analoger Weise kann die Rückplatte eines aus Gehäuseschalen bestehenden Gehäuses schraublos befestigt werden.

Darüber hinaus ist die Erfindung grundsätzlich zur Befestigung von Platten oder plattenförmigen Bauteilen geeignet. Beispielsweise können auch Öffnungen in Seitenwänden oder in einer Deck- oder Bodenfläche eines Gehäuses mit schraublos befestigbaren Platten versehen werden. Die mit der erfindungsgemäßen Anordnung von Federelementen und elastischem Dichtungsprofil zusammenwirkenden Haltestege oder Befestigungsflansche können dabei z.B. zusätzlich am Umfang der Öffnung angebracht werden.

Die Erfindung wird nachstehend anhand einer Zeichnung weiter erläutert; in dieser zeigen in einer stark schematisierten Darstellung
- Fig. 1: ein erfindungsgemäßes Gehäuse in einer Explosionsdarstellung;
- Fig. 2: einen horizontalen Schnitt durch einen frontseitigen Bereich eines erfindungsgemäßen Gehäuses mit schraublos befestigter Frontplatte und
- Fig. 3: eine perspektivische Darstellung eines EMV-Federbandes mit Federelementen.

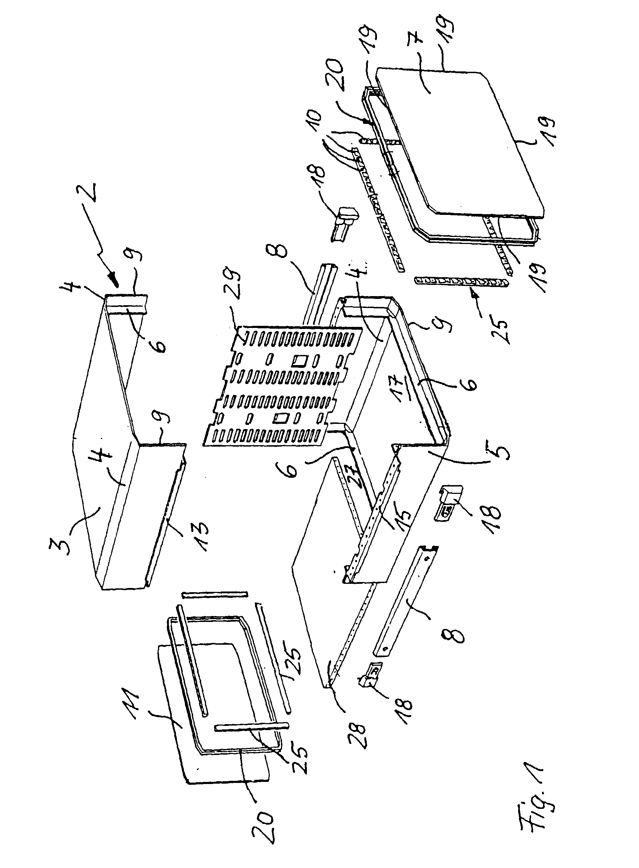

In Figur 1 ist als ein Gehäuse 2 ein Tischgehäuse dargestellt, welches zwei U-förmige Halbschalen als Gehäuseschalen 3, 5 sowie eine Frontplatte 7 und eine Rückplatte 11 aufweist.

Die Gehäuseschalen 3, 5 sind aus einem einteiligen Zuschnitt gefertigt und weisen nach außen gerichtetete Abkantungen 13, 15 auf, welche der Verbindung der Gehäuseschalen 3, 5 dienen. Zur Abdeckung der miteinander verbundenen Abkantungen 13, 15 sind Seitenleisten 8 vorgesehen, die im Bereich einer frontseitigen Öffnung 17 und einer rückseitigen Öffnung 27 mit insbesondere aufsteckbaren Eckelementen 18 komplettiert werden können.

Die in diesem Ausführungsbeispiel identisch ausgebildeten U-förmigen Gehäusehalbschalen 3, 5 weisen Eckschrägen 4 auf, in deren Bereich der umlaufende Haltesteg 6 auf Gehrung geschnitten und beispielsweise verschweißt ist. Zum Einbau von Bauelementen und Baugruppen sind weitere Konstruktionselemente vorgesehen, von denen lediglich beispielhaft eine Montageseitenwand 29 und eine Montageplatte 28 dargestellt sind.

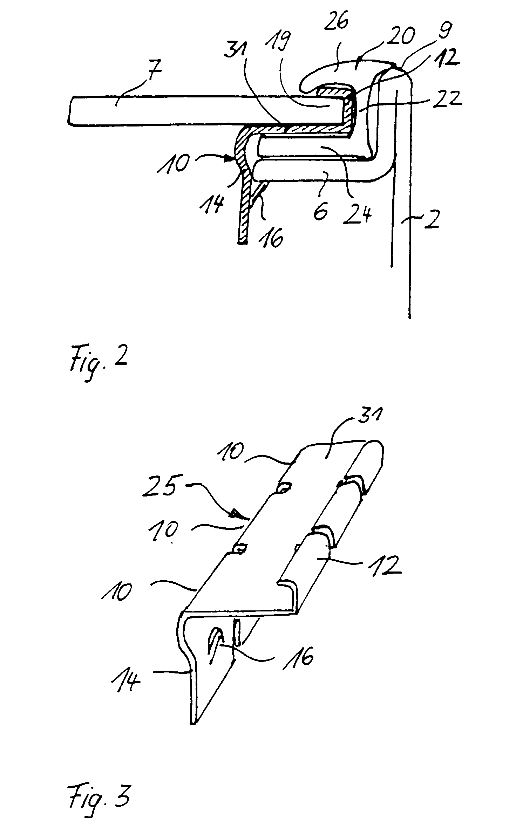

Die kostengünstige Fertigung der Gehäusehalbschalen 3, 5 aus einem einzigen Zuschnitt mit Ausbildung eines in das Gehäuseinnere gerichteten Haltestegs 6 geht aus einer ausschnittsweisen Darstellung eines frontseitigen Bereiches in Figur 2 hervor. Der Haltesteg 6 verläuft danach nahezu rechtwinklig zu dem Gehäuse 2 und zu einem Kantenbereich 9, welcher als eine 180° -Abwinklung einen besonders stabilen Kantenbereich bildet.

Figur 2 zeigt in einer Vergrößerung die schraublose Befestigung der Frontplatte 7 im Bereich des Haltestegs 6 und des Gehäusekantenbereiches 9.

Diese schraublose Befestigung erfolgt im Zusammenwirken mit einer Kombination eines entsprechend ausgebildeten Dichtrahmens 20, welcher aus einem elastischen Kunststoffprofil gebildet wird, und Federelementen 10 aus einem leitfähigen Material, welche insbesondere als ein ablängbares Federband 25 (siehe Fig. 1) angeordnet sind.

Um die Frontplatte 7 in der frontseitigen Öffnung 17 der miteinander verbundenen Gehäuseschalen 3, 5 zu befestigen, wird zunächst ein EMV-Federband 25 in der erforderlichen Länge auf Kantenbereiche 19 der Frontplatte 7 aufgesteckt. Dabei sollten wenigstens Längskanten 19 der Frontplatte 7 mit jeweils einem Federband 25 versehen werden. Auf die an den Längskanten angeordneten Federelemente 10 sowie auf die Kanten der Eckschrägen 4 wird der Dichtrahmen 20 aufgebracht, wobei dieser derart dimensioniert ist, daß die Federelemente 10 in einem Aufsteckbereich 12 weitestgehend abgedeckt und dadurch gehalten werden.

Die derart komplettierte Frontplatte 7 wird danach in die frontseitige Öffnung 17 eingedrückt, wobei ein Innenschenkel 24 und ein Verbindungsschenkel 22 des Dichtrahmens 20 elastisch verformt, insbesondere zusammengedrückt, werden. Die Fixierung wird insbesondere mit einem Klemmsteg 14 erreicht, der etwa rechtwinklig vom Aufsteckbereich 12 der EMV-Federelemente 10 und in das Gehäuseinnere gerichtet ist.

Dieser zunächst bogenförmig und danach linear ausgebildete Klemmsteg 14 weist zum Gehäuse 2 gerichtete Ausprägungen oder Ausstanzungen 16, im vorliegenden Beispiel etwa dreieckige Krallen auf, welche hinter dem Haltesteg 6 verrasten und auf diese Weise die Frontplatte 7 mit Dichtrahmen 20 und EMV-Federelementen 10 kraftschlüssig halten.

Der Dichtrahmen 20, welcher in der in Fig. 2 gezeigten Ausbildung etwa einen T-förmigen Querschnitt mit einem nahezu horizontalen Innenschenkel 24 aufweist, übergreift mit einem Außenschenkel 26 im wesentlichen den Aufsteckbereich 12 der EMV-Federelemente 10 und sicherte eine IP-Abdichtung des Gehäuses im Bereich der Frontplatte 7 und der vorderen Gehäusekante 9.

Aus Figur 3 geht eine mögliche Ausbildung der EMV-Federelemente 10 hervor. Die Federelemente 10 sind als ein EMV-Federband 25 ausgebildet und über einen Anlagesteg oder Anlagebereich 31, welcher nahezu horizontal und durchgehend ausgebildet ist und im fixierten Zustand an einer Innenfläche der Frontplatte 7 anliegt, miteinander verbunden.

Besonders vorteilhaft ist ein aus Edelstahl gefertigtes EMV-Federband, welches nach Art eines Doppelhakens ausgebildet ist und gemäß Figur 2 auf die Kanten 19 einer Frontplatte 7 aufsteckbar und an einem Haltesteg 6 eines Gehäuses 2 einrastbar oder verklemmbar ist.

In einer Weiterbildung der Erfindung können die EMV-Federelemente in eine Frontplatte oder in jede andere Abdeckplatte einer Gehäuseöffnung integriert sein. Die Ausbildung der Abdeckplatten mit integrierten EMV-Federelementen kann beispielsweise in einem Stanz- und Biegeprozeß erfolgen. Es genügt dann ein entsprechend ausgebildeter Dichtrahmen, welcher mit Klemmelementen der EMV-Federelemente zusammenwirkt, um eine schraublose Befestigung einer Frontplatte zu gewährleisten.

## Patentansprüche

1. Gehäuse zur Aufnahme von elektrischen und elektronischen Baugruppen,
mit einer in einer frontseitigen Öffnung (17) angeordneten Frontplatte (7),
wobei die Frontplatte (7) an einem Haltesteg ( 6) des Gehäuses (2) angeordnet ist, welcher die frontseitige Öffnung (17) in einer zurückgesetzten Anordnung umgibt und in die frontseitige Öffnung (17) ragt, und dadurch **gekennzeichnet,**
daß eine Anordnung aus leitfähigen Federelementen (10) und einer elastischen Dichtung (20) vorgesehen ist, welche die Frontplatte (7) schraublos sowie EMV-abgeschirmt und IP-dicht hält.

2. Gehäuse nach Anspruch 1,
dadurch **gekennzeichnet,**
daß die leitfähigen Federelemente (10) als haken- oder klammerartige EMV-Federelemente (10) ausgebildet und auf Kanten (19) der Frontplatte (7) aufsteckbar sind.

3. Gehäuse nach Anspruch 1 oder 2,
dadurch **gekennzeichnet,**
daß die elastische Dichtung (20) als ein IP-Dichtrahmen (20) ausgebildet ist, welcher unter Halterung der kantenseitig angeordneten EMV-Federelemente (10) auf die Frontplatte (7) aufsteckbar ist.

4. Gehäuse nach einem der vorhergehenden Ansprüche,
dadurch **gekennzeichnet,**
daß die EMV-Federelemente (10) doppelhakenartig ausgebildet sind, mit einem U-förmigen Aufsteckbereich (12) auf die Kanten (19) der Frontplatte (7) aufsteckbar und mit einem Klemmsteg (14), welcher in das Gehäuse (2) gerichtet ist, an dem Haltesteg (6) des Gehäuses (2) fixierbar ist.

5. Gehäuse nach einem der vorhergehenden Ansprüche,
dadurch **gekennzeichnet,**
daß die EMV-Federelemente (10) Rast- oder Klemmelemente, insbesondere Ausprägungen oder Ausstanzungen (16) aufweisen, welche nach einem Eindrücken der Frontplatte (7) mit aufgesteckten EMV-Federelementen (10) und IP-Dichtrahmen (20) hinter dem Haltesteg (6) des Gehäuses (2) einrasten.

6. Gehäuse nach einem der vorhergehenden Ansprüche,
dadurch **gekennzeichnet,**
daß der Dichtrahmen (20) einen Außenschenkel (26) aufweist, welcher den Aufsteckbereich (12) der EMV-Federelemente (10) abdeckt und insbesondere bis auf die Frontplatte (7) sowie bis zu einer Gehäusekante (9) reicht.

7. Gehäuse nach einem der vorhergehenden Ansprüche,
dadurch **gekennzeichnet,**
daß der Dichtrahmen (20) mit dem Außenschenkel (26), einem Verbindungsschenkel (22) und einem Innenschenkel (24) zwischen der Frontplatte (7), welche mit EMV-Federelementen (10) versehen ist, und dem Gehäuse (2) angeordnet ist.

8. Gehäuse nach einem der vorhergehenden Ansprüche,
dadurch **gekennzeichnet,**
daß der Dichtrahmen (20) aus einem elastischen Kunststoffprofil durch Ablängen und Verbinden gebildet ist.

9. Gehäuse nach einem der vorhergehenden Ansprüche,
dadurch **gekennzeichnet,**
daß bei einer fixierten Frontplatte (7) der Verbindungsschenkel (22) und der Innenschenkel (24) des Dichtrahmens (20), welche etwa rechtwinklig zueinander ausgebildet sind, elastisch verformbar an dem Haltesteg (6) und an dem Kantenbereich (9) des Gehäuses (2) anliegen.

10. Gehäuse nach einem der vorhergehenden Ansprüche,
dadurch **gekennzeichnet,**
daß es aus zwei U-förmigen Halbschalen (3, 5) gebilet ist und eine Rückplatte (11), welche in einer rückseitigen Öffnung (27) angeordnet ist, mit einer Anordnung aus EMV-Federelementen (10) und einem IP-Dichtrahmen (20) schraublos gehalten ist.

11. Gehäuse nach einem der vorhergehenden Ansprüche,
dadurch **gekennzeichnet,**
daß die EMV-Federelemente (10) als ein EMV-Federband (25) ausgebildet und/oder aus Edelstahl gefertigt sind.

12. Gehäuse nach einem der vorhergehenden Ansprüche,
dadurch **gekennzeichnet,**
daß die EMV-Federelemente (10) über einen Anlagebereich oder einen Anlagesteg (31), welcher zwischen dem Aufsteckbereich (12) und dem Klemmsteg (14) als eine nahezu durchgehende Fläche ausgebildet ist, zu einem Federband (25) verbunden sind.

13. Gehäuse nach Anspruch 1,
dadurch **gekennzeichnet,**
daß EMV-Federelemente (10) oder ein EMV-Federband (25) in die Frontplatte (7) integriert sind und daß die Frontplatte (7) mit einem IP-Dichtrahmen (20) in die frontseitige Öffnung (17) schraublos einklemmbar oder verrastbar ist.

14. Gehäuse nach Anpruch 1 oder 13,
dadurch **gekennzeichnet,**
daß Seitenplatten und/oder Deck- und/oder Bodenplatten mit einer Anordnung aus EMV-Federelementen (10) und einem IP-Dichtrahmen (20) schraublos in Öffnungen in Seitenwänden, einer Deckfläche und/oder einer Bodenfläche fixierbar sind.

## Claims

1. Housing for receiving electrical and electronic modules with a front panel (7) located in a frontal opening (17), wherein the front panel (7) is placed on a retaining web (6) of the housing (2), which surrounds the frontal opening (17) in a setback arrangement and projects into the frontal opening (17),
**characterized** in that
an arrangement of conductive spring elements (10) and an elastic seal (20) is provided, which keeps the front panel (7) screwless, EMC-shielded and IP-tight.

2. Housing according to claim 1,
**characterized** in that
the conductive spring elements (10) are constructed as hook- or clip-like EMC spring elements (10) and can be mounted on edges (19) of the front panel (7).

3. Housing according to claim 1 or 2,
**characterized** in that
the elastic seal (20) is constructed as an IP-sealing frame (20), which whilst retaining the edge-side arranged EMC spring elements (10) can be mounted on the front panel (7).

4. Housing according to one of the preceding claims,
**characterized** in that
the EMC-spring elements (10) have a double hook-like construction and can be slipped onto the edges (19) of the front panel (7) with a U-shaped slip-on area (12) and can be fixed on the retaining web (6) of the housing (2) with a clamping web (14) directed into the housing (2).

5. Housing according to one of the preceding claims,
**characterized** in that
the EMC-spring elements (10) have locking or clamping elements, particularly stamped or punched elements (16), which following a pressing in of the front panel (7) with mounted EMC-spring elements (10) and IP-sealing frame (20) engage behind the retaining web (6) of of the housing (2).

6. Housing according to one of the preceding claims,
**characterized** in that
the sealing frame (20) has an outer leg (26), which covers the slip-on area (12) of the EMC-spring elements (10) and in particular extends to the front panel (7) and to a housing edge (9).

7. Housing according to one of the preceding claims,
**characterized** in that
the sealing frame (20) with the outer leg (26), a connecting leg (22) and an inner leg (24) is placed between the front panel (7), which is provided with EMC-spring elements (10), and the housing (2).

8. Housing according to one of the preceding claims,
**characterized** in that
the sealing frame (20) is formed from an elastic plastics profile by cutting to length and joining.

9. Housing according to one of the preceding claims,
**characterized** in that
when the front panel (7) is fixed, the connecting leg (22) and inner leg (24) of the sealing frame (20), which are constructed approximately at right angles to one another, engage in elastically deformable manner on the retaining web (6) and on the edge region (9) of the housing (2).

10. Housing according to one of the preceding claims,
**characterized** in that
it is formed from two U-shaped half-shells (3, 5) and a back panel (11), which is located in a back opening (27), being held in screwless manner with an arrangement of EMC-spring elements (10) and an IP-sealing frame (20).

11. Housing according to one of the preceding claims,
**characterized** in that
the EMC-spring elements (10) are constructed as an EMC-spring strip (25) and/or from high grade steel.

12. Housing according to one of the preceding claims,
**characterized** in that
the EMC-spring elements (10) are connected to a spring strip (25) by means of a bearing area or bearing web (31), which is constructed between the slip-on area (12) and the clamping web (14) as a virtually through surface.

13. Housing according to claim 1,
**characterized** in that
EMC-spring elements (10) or a EMC-spring strip (25) are integrated in the front plate (7), and the front plate (7) with an IP-sealing frame (20) can be clamped on or locked into the frontal opening (17) screwless.

14. Housing according to claim 1 or 13,
**characterized** in that
side panels and/or top and/or bottom plates having an arrangement of EMC-spring elements (10) and an IP-sealing frame (20) are fixable screwless in openings in side walls, a top and/or a bottom surface.

## Revendications

1. Boîtier destiné à recevoir des sous-ensembles électriques et électroniques, avec une plaque frontale (7) placée dans une ouverture frontale (17), la plaque frontale (7) étant placée sur une barre de retenue (6) du boîtier (2) qui entoure l'ouverture frontale (17) selon une disposition en retrait et forme saillie dans l'ouverture frontale (17), et ***caractérisé en ce qu'***un agencement d'éléments ressorts conducteurs (10) et d'un joint élastique (20) est prévu, qui maintient la plaque frontale (7) sans vis et avec un effet de blindage électromagnétique et d'étanchéité normes IP.

2. Boîtier selon la Revendication 1, ***caractérisé en ce que*** les éléments ressorts conducteurs (10) sont conformés en éléments ressorts anti-électromagnétiques (10) de type crochet ou griffe et peuvent être enfichés sur des arêtes (19) de la plaque frontale (7).

3. Boîtier selon la Revendication 1 ou 2, ***caractérisé en ce que*** le joint élastique (20) est conformé en cadre d'étanchéité normes IP (20) qui peut être enfiché sur la plaque frontale (7) en maintenant les éléments ressorts anti-électromagnétiques (10) placés côté arête.

4. Boîtier selon l'une quelconque des Revendications précédentes, ***caractérisé en ce que*** les éléments ressorts anti-électromagnétiques (10) sont conformés en doubles crochets, peuvent être enfichés sur les arêtes (19) de la plaque frontale (7) avec une zone d'enfichage (12) en forme de U et peuvent être fixés à la barre de retenue (6) du boîtier (2) avec une barre de blocage (14) qui est orientée vers l'intérieur du boîtier (2).

5. Boîtier selon l'une quelconque des Revendications précédentes, ***caractérisé en ce que*** les éléments ressorts anti-électromagnétiques (10) présentent des éléments d'encliquetage ou de blocage, en particulier des empreintes ou des estampages (16), qui s'enclenchent derrière la barre de retenue (6) du boîtier (2) après l'enfoncement de la plaque frontale (7) avec les éléments ressorts anti-électromagnétiques (10) et le cadre d'étanchéité normes IP (20) enfichés.

6. Boîtier selon l'une quelconque des Revendications précédentes, ***caractérisé en ce que*** le cadre d'étanchéité (20) présente une aile extérieure (26) qui recouvre la zone d'enfichage (12) des éléments ressorts anti-électromagnétiques (10) et arrive en particulier jusqu'à la plaque frontale (7) et jusqu'à une arête (9) du boîtier.

7. Boîtier selon l'une quelconque des Revendications précédentes, ***caractérisé en ce que*** le cadre d'étanchéité (20) avec l'aile extérieure (26), une aile de liaison (22) et une aile intérieure (24), est placé entre la plaque frontale (7), laquelle est munie des éléments ressorts anti-électromagnétiques (10), et le boîtier (2).

8. Boîtier selon l'une quelconque des Revendications précédentes, ***caractérisé en ce que*** le cadre d'étanchéité (20) est formé d'un profilé en matière synthétique élastique par découpe en longueur et assemblage.

9. Boîtier selon l'une quelconque des Revendications précédentes, ***caractérisé en ce que***, sur une plaque frontale (7) fixée, l'aile de liaison (22) et l'aile intérieure (24) du cadre d'étanchéité (20), qui sont conformées approximativement perpendiculaires l'une à l'autre, s'appuient de manière élastiquement déformable contre la barre de retenue (6) et contre la zone d'arête (9) du boîtier (2).

10. Boîtier selon l'une quelconque des Revendications précédentes, ***caractérisé en ce qu***'il est formé de deux demi-coques en forme de U (3, 5) et une plaque arrière (11), qui est placée dans une ouverture arrière (27), est tenue sans vis avec un système d'éléments ressorts anti-électromagnétiques (10) et de cadre d'étanchéité normes IP (20).

11. Boîtier selon l'une quelconque des Revendications précédentes, ***caractérisé en ce que*** les éléments ressorts anti-électromagnétiques (10) sont conformés en bande ressort anti-électromagnétique (25) et/ou sont fabriqués en acier spécial.

12. Boîtier selon l'une quelconque des Revendications précédentes, ***caractérisé en ce que*** les éléments ressorts anti-électromagnétiques (10) sont reliés en une bande ressort (25) par l'intermédiaire d'une zone d'appui ou d'une barre d'appui (31), qui est conformée sous la forme d'une surface quasiment continue entre la zone d'enfichage (12) et la barre de blocage (14).

13. Boîtier selon la Revendication 1, ***caractérisé en ce que*** des éléments ressorts anti-électromagnétiques (10) ou une bande ressort anti-électromagnétique (25) sont intégrés à la plaque frontale (7) et *en ce que* la plaque frontale (7) peut être bloquée ou encliquetée sans vis dans l'ouverture frontale (17) avec un cadre d'étanchéité normes IP (20).

14. Boîtier selon la Revendication 1 ou 13, ***caractérisé en ce que*** des plaques latérales et/ou des plaques de dessus et/ou de fond peuvent être fixées sans vis avec un système d'éléments ressorts anti-électromagnétiques (10) et d'un cadre d'étanchéité normes IP (20) dans des ouvertures de parois latérales, d'une surface de dessous et/ou d'une surface de fond.
